# EUROPEAN PATENT SPECIFICATION

(11) **EP 1 760 476 B1**
(45) Date of publication and mention of the grant of the patent: **22.08.2012**
(21) Application number: 06254550.4
(22) Date of filing: 31.08.2006
(51) Int. Cl.: G01R 23/16

(54) **Data processing method for spectrum analyzer**
Datenverarbeitungsverfahren für einen Spektrumanalysator
Procédé de traitement des données pour analyseur de spectre

(30) Priority: 02.09.2005 JP 2005255088
(43) Date of publication of application: 07.03.2007
(73) Proprietor: Tektronix International Sales GmbH, Neuhausen 82 Schaffhausen (CH)
(72) Inventor: Hosoi, Osamu, Tokyo 143-0015 (JP); Nara, Akira, Tokyo 187-0021 (JP)
(74) Representative: Want, Clifford James

(56) References cited:
- EP-A- 1 592 131
- WO-A-2005/050841
- JP-A- 2003 215 179
- US-A1- 2005 021 261

## Description

### BACKGROUND OF THE INVENTION

The present invention relates to data processing for a signal analyzer using FFT calculation, especially to data processing for a signal analyzer for simulating results that a swept spectrum analyzer using a video filter would provide.

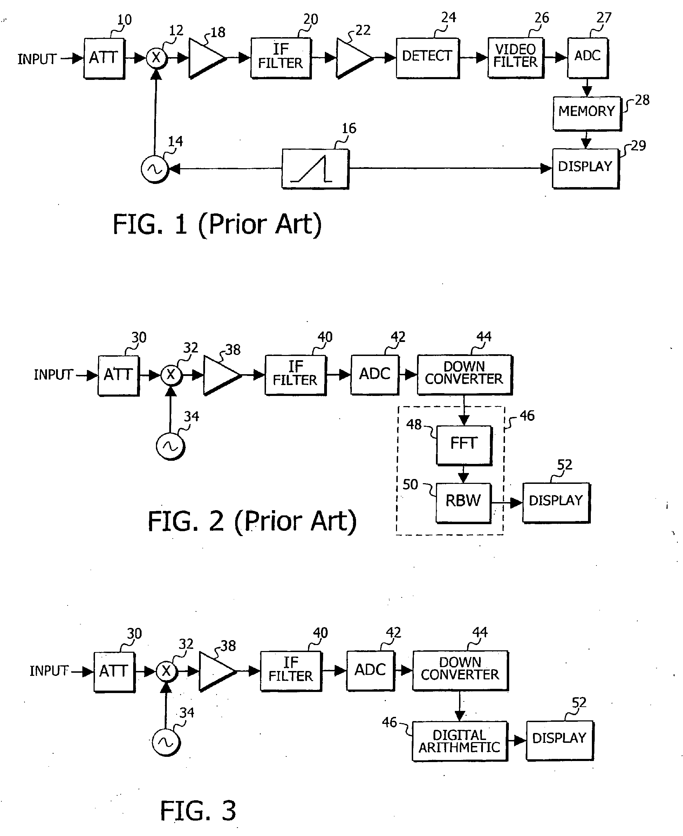

Fig. 1 is a block diagram of an example of a swept spectrum analyzer. A control means (not shown) including microprocessor, memory, and hard disk drive, etc. controls block operations according to settings by a user through an operation panel as is well known in the art. An input variable attenuator 10 adjusts the level of an input signal under test and a mixer 12 mixes it with a local signal from a sweep frequency oscillator 14. The frequency of the local signal changes according to a sweep signal (ramp waveform) from a sweep signal generator 16. This processing leads to a linear relationship between frequency and time changes on a resultant spectrum signal. The time for one frequency sweep is the sweep time. An intermediate frequency (IF) amplifier 18 amplifies the output of the mixer 12 and an IF filter 20 passes it through a bandwidth, or RBW (Resolution Bandwidth) set by a user. A logarithmic amplifier 22 amplifies and a detector 24 detects it to produce a spectrum signal.

A video filter 26 is a low pass filter and reduces noise due to circuits following the IF filter 20 by setting the bandwidth (VBW: Video Bandwidth) properly. The video filter 26 also reduces noise of an incoming signal display as displayed on screen in similar fashion to averaging. It does not reduce the average noise (as would the case with a resolution bandwidth (RBW) reduction), but it does reduce the peak to peak amplitude excursion, also referred to as the "top-to-bottom thickness" of noise or noise-like signals. Note that the video filter 26 is applied to the spectrum signal, which is a time function. An analog to digital converter (ADC) 27 converts the output of the video filter 26 into digital data. The digital data is stored in a memory 28 and displayed as a display spectrum waveform on the screen of a display 29 of which horizontal axis is frequency while it cooperates with the sweep signal from the sweep signal generator 16. It uses a linear relationship between the frequency change of the spectrum signal and the time change over the sweep. The waveform is displayed after the memory 28 stores the data, which prevents intensity of the spectrum waveform from becoming too faint to easily observe. A frequency span (frequency range) on the frequency axis of the screen is changed according to the user setting.

The narrower RBW and VBW become, the slower responses of the filters 20 and 26 become, which requires making the sweep time slower. The control means automatically selects a proper sweep time while considering the selected frequency span. However, the user could set an arbitrary sweep time. Such a swept spectrum analyzer is disclosed by U. S. Patent 6191571, for example.

Fig. 2 is a block diagram of a signal analyzer using FFT calculation, such as a FFT-based spectrum analyzer. Similar to Fig.1, a control means including microprocessor, memories, hard disk drive, etc. controls each block according to settings by a user through an operation panel. An input signal under test is provided to a mixer 32 through an input attenuation circuit 30 and mixed with a local signal from a local oscillator 34. The frequency of the local signal is changed according to the user setting, but the frequency is not swept, which is different from the swept-type spectrum analyzer shown in Fig. 1. The output of the mixer 32 is converted into an intermediate frequency (IF) signal through IF amplifier 38 and IF filter 40 and an analog to digital converter (ADC) 42 converts it into digital data. The IF filter 40 mainly works to remove an image frequency but not to define the RBW, which is different from the case of Fig. 1.

A digital down converter 44 may further digitally down convert the digital data from the ADC 42, which may be realized by a digital signal processor (DSP). An FFT (fast Fourier transform) arithmetic block 48 receives the data from the converter 44 and produces the number N (N is a natural number and may be 1024 for example) of spectrum data per frame which are derived from the time domain data acquired every predetermined period (i.e. frame). An RBW arithmetic block 50 applies filter characteristics of an RBW virtually equivalent to the IF filter 20 to the spectrum data of frequency domain data by digital calculation according to a RBW setting by the user to reduce the noise components. The microprocessor can perform the FFT and RBW calculations, for example. Alternatively, the FFT and RBW calculations may be performed in a dedicated circuit, such as a DSP, and ASIC or an FPGA. A display 52 displays the produced spectrum data as a spectrum waveform on the screen that has a horizontal axis of frequency according to a frequency span set by the user. The spectrum waveform of the set frequency span is displayed by the spectrum data of one frame.

The signal analyzer shown in Fig. 2 has no element to increase noise after getting the spectrum because it digitizes the input signal to obtain the spectrum by FFT calculation.

Some legacy frequency analysis procedures call for the use of a swept spectrum analyzer and the measurement condition defines the video bandwidth (VBW) to be used. Under the defined measurement condition, the FFT-based spectrum analyzer, or signal analyzer, cannot replace the swept spectrum analyzer because it can not set the VBW since it has no video filter and the FFT-based analyzer cannot ensure compatibility with the swept spectrum analyzer.

The document JP 2003-215179 describes a method and circuit for frequency conversion processing.

The details and improvements over the prior solutions will be discussed in greater detail below.

### SUMMARY OF THE INVENTION

The present invention is defined in the independent claim 1. Accordingly, a signal analyzer, or spectrum analyzer, using FFT calculations that is able to set an equivalent VBW to obtain a result equivalent to using the analog video filter is provided. As described, the signal analyzer does not produce noise after the spectrum is produced but the result is different depending on whether the video filter is applied to a signal under test. Therefore if the video filter characteristics are applicable to the FFT signal analyzer, such as an FFT-type spectrum analyzer, it can keep compatibility with a result measured by a swept spectrum analyzer.

A signal analyzer has a digitizing means for converting an input signal into an intermediate frequency signal and digitizing it to produce digital data, a digital arithmetic means for calculating and producing spectrum data from the digital data, and a display means for displaying the spectrum data wherein it essentially does not require a video filter. The present invention, however, provides data processing method for a signal analyzer emulating a swept spectrum analyzer with a video filter.
The video filter is applied to a spectrum signal that is a time function but the spectrum data that the FFT signal analyzer produces has no immediately apparent relationship between frequency and time changes, so it is necessary to define the correspondence between the frequency and time changes. Therefore the present invention replaces the frequency change of the spectrum data with the corresponding time change, and then desired filter characteristics are applied to it. In particular, a predetermined time is assigned to a frequency span to replace the frequency change of the spectrum data with the time change. The predetermined time corresponds to a sweep time as would be used in a swept spectrum analyzer and can be selected properly according to frequency span, resolution bandwidth (RBW) and video bandwidth (VBW) set by a user. A frequency span is assumed to correspond to a virtually defined sweep time and then frequency and time changes are defined to have a linear relationship so that the number N of spectrum data are deemed to be in time series. Then the spectrum data can be processed as if it were time domain data to which video filter characteristics are applied to get a result equivalent to applying the video filter.

One method for applying the desired filter characteristics may be that the digital arithmetic means converts the spectrum data of which frequency change is replaced with the time change into frequency domain data, applies the desired filter characteristics to the frequency domain data and then convert it back to time domain data. Another method may be that the digital arithmetic means conducts a convolution integral between the spectrum data of which frequency change is replaced with the time change and an impulse response of the filter.

Embodiments of the present invention enables a signal analyzer to set a video bandwidth (VBW) of a video filter equivalently and then allows the signal analyzer to replace a swept spectrum analyzer.

### BRIEF DESCRIPTION OF THE DRAWINGS

Fig. 1 is a block diagram of an example of a swept spectrum analyzer.

Fig. 2 is a functional block diagram of an example of a conventional signal analyzer.

Fig. 3 is a functional block diagram of an example of a signal analyzer according to the present invention.

Fig. 4 is a flow chart of data processing by the signal analyzer according to the present invention.

Fig. 5 is a flow chart of another example of a method for applying the filter characteristics.

### DETAILED DESCRIPTION OF THE INVENTION

Fig. 3 is a functional block diagram of a signal analyzer according to the present invention wherein blocks corresponding to those of the conventional example are indicated by the same numbers. A control means including microprocessor, memory, hard disk drive, etc. controls operation of each block according to settings through an operation panel by a user. Program for controlling the circuit operation may be previously stored in a memory means such as the hard disk drive, etc.

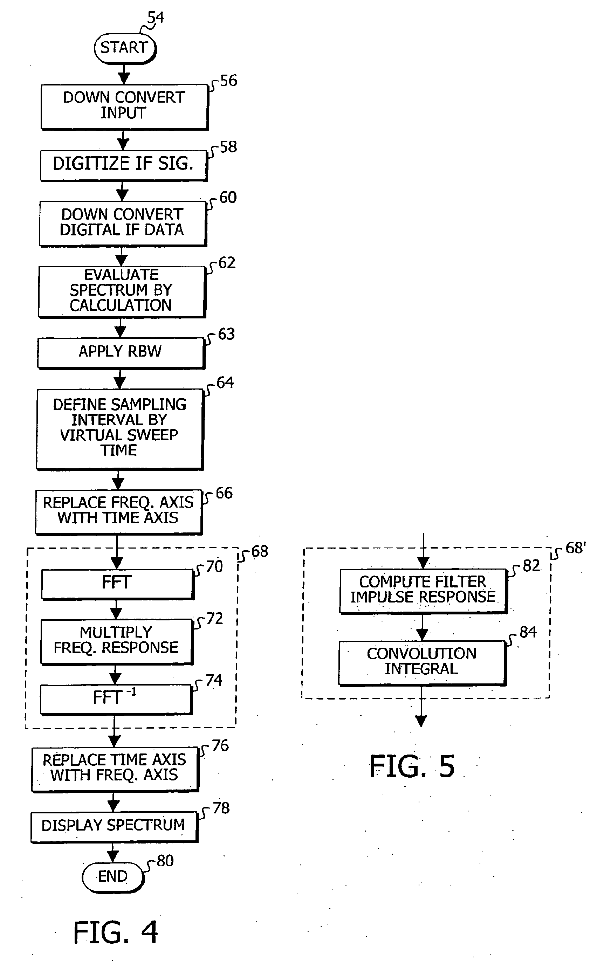

The signal analyzer according to the present invention is different in the data processing by a digital arithmetic block 46 relative to the conventional one shown in Fig. 2. Referring to Figs.3 and 4, which show a signal analyzer similar to the a the FFT-type signal analyzer shown in Fig. 2, an input variable attenuation circuit 30 adjusts the level of an input signal under test and it is provided to a mixer 32 and mixed with a local signal from a local oscillator 34. The output of the mixer 32 passes IF amplifier 38 and IF filter 40 and is down converted into an intermediate frequency signal (step 56) and then an analog to digital converter (ADC) 42 converts it into digital data (step 58). A digital down converter 44, which may be a digital signal processor (DSP), further digitally down converts the digital IF data from the ADC 42 (step 60). A digital arithmetic block 46 performs digital calculation as described below as well as FFT and RBW calculations similar to the conventional one. As described above, time domain IF data obtained every predetermined time (frame) is converted into the number N (N is a natural number, 1024 for example) of frequency domain data (spectrum data) in the FFT calculation (step 62). The filter characteristics defined by the RBW (resolution bandwidth) set by a user is applied to the spectrum data of the frequency domain data respectively (step 63). The FFT and RBW calculations may be done by arithmetic process of the microprocessor, for example.

As described above, the video filter is applied to a spectrum signal as a time function. However, the spectrum data produced by the signal analyzer is the frequency domain data and has no direct relationship between the frequency and time changes so that the video filter characteristics cannot be applied to it directly. Therefore a process is necessary to treat the spectrum data of the frequency domain data as if it were time domain data.

A spectrum signal of a swept spectrum analyzer is produced when that spectrum analyzer sweeps across a frequency span during a predetermined sweep time. In case of the FFT-type signal analyzer, the number N of spectrum data in one frame displays a spectrum waveform across a frequency span. A sweep time can be virtually assigned to a frequency span of the signal analyzer's display spectrum waveform. That is, if the number N of spectrum data in one frame were considered to be time-series data produced during the sweep time, it could make the spectrum data correspond to a spectrum signal of a swept spectrum analyzer.

Specifically, let a virtual sweep time be Tsw that corresponds to a sweep time of a swept spectrum analyzer and then define the number N of spectrum data in one frame produced as one for every virtual sampling interval Ts = Tsw / N. That is, a linear relationship between the frequency change of the spectrum data and the apparent time change is defined. This relationship allows the number N of the spectrum data produced by the signal generator to be dealt with as if it were time domain data. An alternative view is that this process assigns a time relationship to the spectrum data and replaces the frequency axis with a time axis (step 66). This allows filtering of the FFT display data as if it were a time waveform.

The virtual sweep time may be arbitrarily selected by the control means according to the frequency span, RBW and VBW set by the user when emulating a swept spectrum analyzer or, alternatively, the user can directly set an arbitrary sweep time with a swept spectrum analyzer in mind. The set VBW (video bandwidth) also does not exist and is a virtual VBW calculated to emulate the VBW function of a swept spectrum analyzer.

A step 68 is a process of applying desired filter characteristics to the spectrum data as if it were time domain data by digital calculation and has additional sub-steps. In step 70, display spectrum data produced by a first FFT, which has had its frequency axis replaced by a corresponding time axis to provide time domain data, , are converted into frequency domain data by another FFT calculation. This second frequency domain data and a frequency response of the filter characteristics are multiplied to apply the filter characteristics to the display data (step 72). After that, the filtered second FFT data are returned to the original spectrum data of the time domain data by inverse Fourier transform calculation (step 74), but now include the VBW filter response. The display time axis is replaced with a frequency axis by inverse operation of the step 66 process, using the defined corresponding relationship between the frequency and time changes (step 76). The result is spectrum data that is now filtered, by the desired VBW. The resultant data may be displayed as a display spectrum on the display 52, for example (step 78). The shape of the characteristics of the video filter is typically Gaussian but other shapes can be selectively provided.

Fig. 5 is a flow chart showing an alternative process block 68 to get the same result as the process block 68B shown in Fig. 4 by another method wherein the data processes other than the respective steps 68 are the same as Fig.4. In the method, an impulse response is calculated based on the desired filter characteristics (VBW) set by the user (step 82), and a convolution integral between the impulse response and the spectrum data of the time domain data is conducted (step 84). Note that the spectrum data are converted into the frequency domain data to conduct the process of the step 68A of Fig. 4, but the data remain time domain data during the calculation in the step 68B of Fig. 5 though these processes provide equivalent results.

A signal analyzer according to the present invention can emulate a swept spectrum analyzer with a video filter even though it does not have an analog video filter. Therefore the present invention allows replacing a swept spectrum analyzer with an FFT-type signal analyzer, such as an FFT-type Spectrum Analyzer for example a real-time spectrum analyzer, even for the frequency analysis that requires a video bandwidth (VBW) setting in the measurement.

## Claims

1. A data processing method for a signal analyzer which is not a swept spectrum analyzer to emulate a swept spectrum analyzer having a video filter, the signal analyzer having: a digitizer for converting (58) an input signal into digital data; digital arithmetic means (46) for producing display spectrum data having a frequency axis from the digital data by calculation; and display means (52) for displaying the spectrum data, the method comprising treating the frequency change of the spectrum data as a time change to allow application of desired filter characteristics to the display spectrum data, and displaying (78) filtered display spectrum data;
wherein using calculation to produce the display spectrum data comprises:
defining (64) a sampling interval based upon a given time corresponding to an equivalent sweep time;
sampling the input signal using the sampling interval to produce display spectrum data;
replacing (66) the frequency axis of the display spectrum data with a time axis;
applying (68) video filter characteristics to the time-based data to produce filtered time-based spectrum data;
replacing (76) the time axis of the filtered time-based spectrum data with the frequency axis to produce filtered display spectrum data; and
displaying (78) the filtered display spectrum data with the frequency axis.

2. The data processing method for a signal analyzer as recited in claim 1 wherein a given time is assigned to a frequency span to allow processing of the frequency change of the display spectrum data as if it were the time change.

3. The data processing method for a signal analyzer as recited in claim 2 wherein the given time is selected based on settings of the frequency span, a resolution bandwidth and a video bandwidth.

4. The method of claim 1, wherein the given time is defined based upon frequency span, resolution bandwidth and video bandwidth.

5. The method of claim 1, wherein the step of applying (68) filter characteristics further comprises:
performing (70) an FFT on the time-based spectrum data to produce frequency domain data;
multiplying (72) the frequency domain data by a frequency response corresponding to the filter characteristics to produce filtered frequency domain data; and
performing (74) an inverse FFT on the filtered frequency domain data to produce filtered time-based spectrum data.

6. The method of claim 1, wherein the step of applying (68') filter characteristics further comprises:
calculating (82) an impulse response based upon the filter characteristics; and
applying (84) a convolution integral between the impulse response and the time-based spectrum data to produce filtered time-based spectrum data.

## Patentansprüche

1. Datenverarbeitungsverfahren für einen Signalanalysator, bei dem es sich um keinen Swept-Spectrum-Analysator zum Emulieren eines Swept-Spectrum-Analysators mit einem Videofilter handelt, wobei der Signalanalysator folgendes aufweist: einen Digitalisierer zum Umwandeln (58) eines Eingangssignals in ein digitales Signal; eine digitale arithmetische Einrichtung (46) zum Erzeugen von Anzeigespektrumdaten mit einer Frequenzachse durch Berechnung aus den digitalen Daten; und eine Anzeigeeinrichtung (52) zum Anzeigen der Spektrumdaten, wobei das Verfahren das Behandeln der Frequenzveränderung der Spektrumdaten als eine zeitliche Veränderung umfasst, um die Anwendung gewünschter Filtereigenschaften auf die Anzeigespektrumdaten zu erlauben, und zum Anzeigen (78) der gefilterten Spektrumdaten; wobei der Einsatz von Berechnungen zum Erzeugen der Anzeigespektrumdaten folgendes umfasst:
das Definieren (64) eines Abtastintervalls auf der Basis einer bestimmten Zeit, die einer äquivalenten Sweepzeit entspricht;
das Abtasten des Eingangssignals unter Verwendung des Abtastintervalls, um Anzeigespektrumdaten zu erzeugen;
das Ersetzen (66) der Frequenzachse der Anzeigespektrumdaten durch eine Zeitachse;
das Anwenden (68) von Videofiltereigenschaften auf die zeitbasierten Daten, um gefilterte zeitbasierte Spektrumdaten zu erzeugen;
das Ersetzen (76) der Zeitachse der gefilterten zeitbasierten Spektrumdaten durch die Frequenzachse, um gefilterte Anzeigespektrumdaten zu erzeugen; und
das Anzeigen (78) der gefilterten Anzeigespektrumdaten mit der Frequenzachse.

2. Datenverarbeitungsverfahren für einen Signalanalysator nach Anspruch 1, wobei eine bestimmte Zeit einer Frequenzspanne zugeordnet wird, um die Verarbeitung der Frequenzveränderung der Anzeigespektrumdaten zu erlauben, als würde es sich dabei um die zeitliche Veränderung handeln.

3. Datenverarbeitungsverfahren für einen Signalanalysator nach Anspruch 2, wobei die bestimmte Zeit ausgewählt wird auf der Basis der Einstellungen der Frequenzspanne, einer Auflösungsbandbreite und einer Videobandbreite.

4. Verfahren nach Anspruch 1, wobei die bestimmte Zeit definiert wird auf der Basis der Frequenzspanne, der Auflösungsbandbreite und der Videobandbreite.

5. Verfahren nach Anspruch 1, wobei der Schritt des Anwendens (68) von Filtereigenschaften ferner folgendes umfasst:
das Ausführen (70) einer FFT an den zeitbasierten Spektrumdaten, um Frequenzbereichsdaten zu erzeugen;
das Multiplizieren (72) der Frequenzbereichsdaten mit einer Frequenzantwort, die den Filtereigenschaften entspricht, um gefilterte Frequenzbereichsdaten zu erzeugen; und
das Ausführen (74) einer inversen FFT an den gefilterten Frequenzbereichsdaten, um gefilterte zeitbasierte Spektrumdaten zu erzeugen.

6. Verfahren nach Anspruch 1, wobei der Schritt des Anwendens (68') von Filtereigenschaften ferner folgendes umfasst:
das Berechnen (82) einer Impulsantwort auf der Basis der Filtereigenschaften; und
das Anwenden (84) eines Faltungsintegrals zwischen der Impulsantwort und den zeitbasierten Spektrumdaten, um gefilterte zeitbasierte Spektrumdaten zu erzeugen.

## Revendications

1. Procédé de traitement de données pour un analyseur de signal qui n'est pas un analyseur de spectre par balayage pour émuler un analyseur de spectre par balayage ayant un filtre vidéo, l'analyseur de signal ayant : un numériseur pour convertir (58) un signal d'entrée en données numériques ; des moyens arithmétiques numériques (46) pour produire des données de spectre d'affichage ayant un axe de fréquence à partir des données numériques par calcul ; et des moyens d'affichage (52) pour afficher les données de spectre, le procédé comprenant les étapes consistant à traiter le changement de fréquence des données de spectre comme un changement de temps pour permettre l'application de caractéristiques de filtre voulues aux données de spectre d'affichage, et afficher (78) des données de spectre d'affichage filtrées ; dans lequel l'utilisation de calcul pour produire les données de spectre d'affichage comprend les étapes consistant à :
définir (64) un intervalle d'échantillonnage basé sur un temps donné correspondant à un temps de balayage équivalent ;
échantillonner le signal d'entrée en utilisant l'intervalle d'échantillonnage pour produire des données de spectre d'affichage ;
remplacer (66) l'axe de fréquence des données de spectre d'affichage par un axe de temps ;
appliquer des caractéristiques de filtre vidéo (68) aux données basées sur le temps pour produire des données de spectre basées sur le temps filtrées ;
remplacer (76) l'axe de temps des données de spectre basées sur le temps filtrées par l'axe de fréquence pour produire des données de spectre d'affichage filtrées ; et
afficher (78) les données de spectre d'affichage filtrées avec l'axe de fréquence.

2. Procédé de traitement de données pour un analyseur de signal selon la revendication 1, dans lequel un temps donné est affecté à une plage de fréquences pour permettre le traitement du changement de fréquence des données de spectre d'affichage comme s'il s'agissait du changement de temps.

3. Procédé de traitement de données pour un analyseur de signal selon la revendication 2, dans lequel le temps donné est sélectionné sur la base de paramètres de la plage de fréquences, d'une bande passante de résolution et d'une bande passante vidéo.

4. Procédé selon la revendication 1, dans lequel le temps donné est défini sur la base d'une plage de fréquences, d'une bande passante de résolution et d'une bande passante vidéo.

5. Procédé selon la revendication 1, dans lequel l'application (68) de caractéristiques de filtre comprend en outre les étapes consistant à :
effectuer (70) une FFT sur les données de spectre basées sur le temps pour produire des données du domaine fréquentiel ;
multiplier (72) les données du domaine fréquentiel par une réponse en fréquence correspondant aux caractéristiques de filtre pour produire des données du domaine fréquentiel filtrées ; et
effectuer (74) une FFT inverse sur les données du domaine fréquentiel filtrées pour produire des données de spectre basées sur le temps filtrées.

6. Procédé selon la revendication 1, dans lequel l'application (68') de caractéristiques de filtre comprend en outre les étapes consistant à :
calculer (82) une réponse impulsionnelle sur la base des caractéristiques de filtre ; et
appliquer (84) une intégrale de convolution entre la réponse impulsionnelle et les données de spectre basées sur le temps pour produire des données de spectre basées sur le temps filtrées.
